# EUROPEAN PATENT APPLICATION

(11) **EP 4 239 411 A1**
(43) Date of publication of application: **06.09.2023**
(21) Application number: 22160228.7
(22) Date of filing: 04.03.2022
(51) Int. Cl.: G03F 7/30, B41N 3/08, B41C 1/10

(54) **METHOD AND APPARATUS FOR PROCESSING A LITHOGRAPHIC PRINTING PLATE PRECURSOR**

(71) Applicant: ECO3 BV, 2640 Mortsel (BE)
(72) Inventor: SINNESAEL, Jan, 2640 Mortsel (BE); HENDRIKX, Peter, 2640 Mortsel (BE)
(74) Representative: Vanderstede, Els

(57) **Abstract**

A method and apparatus for processing a lithographic printing plate precursor, comprising development with a first gum solution and subsequently with a second gum solution, wherein both gum solutions are provided in a cascade configuration whereby the second gum solution overflows into the first gum solution and the development is combined with mechanical rubbing and/or brushing by one or more flat brushes.

## Description

### FIELD OF THE INVENTION

The present invention relates to a method and apparatus for efficiently processing lithographic printing plate precursors with a reduced consumption of processing liquids.

### BACKGROUND OF THE INVENTION

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. These areas can also be referred to as printing and non-printing areas respectively or as image and non-image areas respectively. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of a printing plate precursor (also referred to hereafter as "plate material" or briefly as "plate"), which contains a heat- or light-sensitive coating on a substrate. The coating of the plate material is exposed image-wise to heat or light, typically by means of a digitally modulated exposure device such as a laser, which triggers a (physico-)chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate materials are capable of producing a lithographic image immediately after exposure, the most popular plate materials require wet processing with a developer since the exposure produces a difference of solubility or of rate of dissolution in a developer between the exposed and the non-exposed areas of the coating. In positive working plate materials, the exposed areas of the coating dissolve in the developer while the non-exposed areas remain resistant to the developer. In negative working plate materials, the non-exposed areas of the coating dissolve in the developer while the exposed areas remain resistant to the developer. Most plate materials contain a hydrophobic coating on a hydrophilic substrate, so that the areas which remain resistant to the developer define the ink-accepting, printing areas of the plate while the hydrophilic substrate is revealed by the dissolution of the coating in the developer at the non-printing areas.

Conventionally, a plate material is developed by immersing it in, or spraying it with a developer as it passes through the processing apparatus. Typically the material is also subjected to mechanical rubbing with e.g. one or more rotating brushes or specified roller(s) - after a while or after being treated with the developer. After development, the plate is typically rinsed with water to remove any remaining developer and then gummed, which is sometimes also called finished or desensitized. Gumming involves the application of a protective coating on the lithographic image, especially the non-printing areas to avoid contamination or oxidation of the aluminum substrate. Gum solution can be applied by immersion, by spraying or by jetting as disclosed for example in EP 1 524 113.

An important trend in lithographic platemaking is related to ecology and sustainability. Systems and methods which enable a low consumption of processing liquids such as developer, rinse water and gum solution, or which allow processing with aqueous developers comprising no hazardous chemicals and/or which have a pH close to 7 (neutral developer), have attracted a lot of attention in the marketplace. A convenient method which has become popular involves the use of a gum solution as developer, whereby the plate is developed and gummed in a single step as described in e.g. EP 1 342 568 and WO 2005/111727.

Such methods however can only be used for specially designed printing plates, which have lithographic coatings that are sufficiently soluble or dispersible in the gum solution so that a good clean-out is obtained. Under "clean-out" is understood the removal of the coating in the non image areas, revealing the hydrophilic surface of the support. This means that the surface of the support should be residue-free in the non image areas. Without such a residue-free removal, so-called toning would occur during printing, i.e. the background areas would accept printing ink. However, it has been observed that often the clean out performance of printing plate precursors decreases during storage; i.e. when the plates are not immediately used for the printing job.

WO2007/057347 discloses a method for making a lithographic printing plate wherein the precursor is washed in a prewashing station comprising two or more prewashing units which have the configuration of a cascade system, whereby the wash liquid used for washing the precursor in the first and second prewashing unit are respectively present in a first and a second tank, and whereby the wash liquid of the second tank overflows to the first tank when fresh water is added in the second prewashing unit.

WO17/75750 and WO17/57571 disclose a method for processing a positive-working lithographic printing plate precursor comprising the steps of treating the plate material with an alkaline development solution followed by treating the plate material with a first gum solution and consecutively with a second gum solution which are configured as a cascade whereby the second gum solution overflows into the first gum solution.

EP1788444 discloses a method for making a lithographic printing plate comprising the steps of image-wise exposing a coating including a photopolymerisable composition followed by treating the precursor in a gumming station, comprising a first and at least a second gumming unit, wherein the precursor is consecutively developed in said first and said second gumming unit with a gum solution, thereby removing non-exposed areas of the photopolymerizable layer from the support and gumming the plate in a single step.

EP1788442 discloses a method for making a lithographic printing plate comprising the steps of image-wise exposing a coating comprising a photopolymerizable layer; heating the precursor in a preheating unit followed by treating the precursor in a gumming station wherein the preheating unit and the gumming unit are coupled to each other by mechanical plate conveying means or are integrated in a single apparatus.

EP1788450 discloses a method for making a lithographic printing plate comprising the steps of image-wise exposing said coating including a photopolymerizable layer and a toplayer; washing the precursor in a prewashing station by applying water or an aqueous solution to the coating, thereby removing at least part of the toplayer and developing the precursor in a gumming station by applying a gum solution to the coating of the precursor, thereby removing the non-exposed areas of the photopolymerizable layer from the support and gumming the plate in a single step.

Despite the various solutions provided in the prior art, it remains a challenge to obtain printing plate precursors which exhibit an excellent clean out behaviour under non-aggressive processing conditions combined with sustainable and robust processing systems which consume low amounts of developer during the production of high quality printing plates. Especially sufficient clean out of printing plates which are not immediately used for the printing job remains a major concern in the art.

### SUMMARY OF THE INVENTION

It is therefore an object of the present invention to provide a method and an apparatus for processing lithographic printing plate precursors which are able to provide an improved clean out of the printing plate precursor and enable the reduction of the consumption of processing liquids such as gum solution and to reduce the amount of waste liquids generated during the processing step(s).

This object is realised by the method and apparatus defined in the independent claims, with preferred embodiments defined in the dependent claims. The invention has the specific feature that the printing plate precursor is, during development with two gum solutions in a cascade configuration, manipulated with mechanical brushing and/or rubbing by one or more flat brush(es). Preferably, the first developing step with the first gum solution is combined with said flat brush(es). The flat brush(es) preferably rub and/or brush the printing plate precursor by moving back and forth in a direction preferably perpendicular or substantially perpendicular to the plate conveying direction through the processor. More details concerning the flat brush(es) are described below.

The development with two gum solutions involves two treatments with gum solution, performed in a first gumming unit comprising a first gum solution and subsequently in a second gumming unit comprising a second gum solution, wherein both gumming units are configured as a cascade, i.e. a configuration wherein the second gum solution overflows into the first gum solution.

A preferred embodiment of the processing apparatus of the present invention is described in more detail below. It was surprisingly found that the use of flat brush(es) during the development step significantly improves the clean out behaviour of the non image areas of printing plate precursors. Moreover, the apparatus highly contributes to the reduction of waste liquids not only because only a small volume of developer/gum may be used but also because a water rinse is not required after the development. Contrary to conventional systems, which consume typically between 5000 I and 10000 I of rinse water for a plate production volume of 20000 m² plates per year, the method and apparatus of the current invention, require for the same production volume less than 5000 I of gum solution per year. Since no water rinse is required, the apparatus may be used in locations where a water supply is not available; i.e. the apparatus can be used as a so-called "stand-alone" apparatus. Therefore, the current invention is not only convenient and cost-efficient, but is also favorable from an environmental point of view.

In summary, the method and apparatus of the present invention not only provides the major advantage of consuming low amounts of processing liquids and thus generating only small amounts of waste liquid but also provides excellent clean out of the non image areas. This advantage is even more pronounced for printing plates which are not immediately used after production but require for example a long transport period and/or are stored in for example warehouses for several months before use. Further objects of the invention will become apparent from the description hereinafter.

### BRIEF DESCRIPTION OF THE DRAWINGS

FIG. 1 is a detailed representation of the flat brushes.
FIG. 2 is a schematic representation of a preferred embodiment of the apparatus of the invention, shown as it is filled with gum solution.

### DETAILED DESCRIPTION OF THE INVENTION

### DEFINITIONS:

Development/Gumming section : part of an apparatus which comprises a development/gumming unit, and preferably also a gum recirculation system and a gum regeneration system. Also referred to herein as "gumming section".

Fresh gum solution : solution which has not yet been used for processing a plate material.

Development/Gumming unit: vessel designed to hold gum solution optionally including nip rollers, optional scavenger rollers, brushe(s) and/or means for supplying gum solution to the plate. Also referred to herein as "gumming unit".

(Re)circulation system : system comprising the necessary pipes and pump(s) to generate the gum solution.

Regeneration system : system comprising the necessary pipes and pump(s) to supply regenerator liquid to a development/gumming unit.

Replenishment solution : regenerator liquid used to enhance the activity level of the gum solution. Replenishment solutions may contain more, less or different ingredients compared to the fresh solution.

(Re)start : the process of draining gum solution from the development/gumming unit, followed by refilling the development/gumming unit with fresh gum solution (the latter step taken alone is referred to as "start").

Unless otherwise indicated, parameter values of a solution, e.g. pH, density, viscosity, conductivity, etc. are always measured at 25°C.

### DEVELOPMENT

According to the current invention, an (exposed) printing plate precursor is developed/gummed by means of a first and a second gum solution provided in a cascade configuration combined with and/or followed by treatment of the wetted printing plate with mechanical rubbing and/or brushing by means of at least one flat brush.

The two gumming steps are carried out in two different gumming units configured as a cascade whereby the second gum solution overflows into the first gumming unit. In the first gumming step, the printing plate precursor is treated with a first gum solution. The main purpose of this treatment is to ensure good clean-out of the non image areas. In the second gumming step, the plate precursor is subsequently treated with a second gum solution. The main purpose of the second step is to protect the lithographic image by the application of a gum layer as further discussed below. It shall be understood, however, that the purpose of the first and second gumming steps is not a limitation of the present invention. For instance, also the second gum solution may contribute to the clean-out of the image, for those plate precursors of which the non-printing areas of the coating are not completely removed after the first developing/gumming step. Reduced clean-out usually results in toning (ink-acceptance in the non-image areas) of the printing plate and/or in ink build-up on the blanket.

During the development step with the gum solutions, the non-printing areas of the coating of the printing plate precursor are at least partially removed without substantially removing the printing areas. The gum solutions become loaded with these components of the coating and especially in the first gum solution the amount of removed coating material increases as more plates are developed. Due to the increasing amount of coating material in the first gum solution, the activity of the gum solution typically decreases which may result in a reduced ability to remove the non-printing areas of the lithographic image and/or a reduced ability to maintain the removed components in solution or in a dispersed state resulting in sludge formation such as salted-out compounds, precipitated or flocculated ingredients and/or other undissolved compounds. As a result, although the first gum solution originates from the second gum solution via the cascade overflow, the composition of the two gum solutions will become different during the use of the method and apparatus of the present invention.

The cascade configuration provides the advantage that sludge formation in the second gum solution is limited and therefor an increase of the viscosity of the second gum solution is strongly delayed and/or even avoided. The second gum solution thus remains less contaminated and can be used for developing/gumming a higher number of plates enabeling a cost efficient and sustainable system. In other words, the cascade set-up results in an improved lifetime of the development/gumming system.

The first gum solution is regenerated by the cascade overflow and may optionally be regenerated by actively pumping gum solution, in addition to the cascade overflow, from the second to the first gumming unit, and/or by replenishing the first gum solution. The second gum solution is preferably regenerated by adding fresh gum and/or replenishing solution within certain periods as described below.

During the processing of the printing plate precursors, the coating of the precursor is rubbed and/or brushed with at least one, two or a plurality of flat brushes while applying the first gum solution. Additionally, the coating is preferably rubbed and/or brushed while applying the second gum solution to the coating. Each of the first and second gumming units is provided with a bath wherein the gum solution is present and wherein the gum solution which is applied onto the printing plate precursor can be collected and conducted to a pump for circulation and to be used several times to develop the precursor.

The gum solutions are preferably brought into contact with the printing plate by spraying, jetting, immersing, dipping or by a coating technique, including spin coating, roll coating, slot coating or gravure coating. The use of spray bars is preferred. A spray bar typically includes a hollow rod with a predetermined series of holes. In the current invention, wetting of the printing plate precursor is preferably performed by providing the gum solution onto the printing plate precursor via the entry roller(s) which are wetted by for example spraying, jetting and/or pouring gum solution onto their surfaces. Most preferably, in the first gumming unit, the gum solution is applied onto the printing plate precursor by means of nozzles present in the flat brushes. These nozzles are preferably provided in the substantially flat support structure of the brush(es) between the bristles (see below). Preferably, a constant supply of fresh liquid is provided. These options of providing gum solution to the printing plate precursor may be combined and are further described herein in more detail.

In a preferred embodiment, a low amount (as defined below) of gum solution is used during a period of about one week or more, preferably about four weeks or more, more preferably about ten weeks or more, and/or after processing at least 4000 m² of precursor and at most 12000 m², during which a plurality of plates is processed with the same gum solution, either with or without regeneration.

Alternatively, the gum quality may be kept constant for a longer period, so that a restart can be postponed for a longer time, for example more than three or four month, preferably more than six months.

After that period, the gumming units are reloaded with fresh gum solution. This process is preferably fully automatic, which means that the gum solutions are drained from the gumming units and that the gumming units are refilled with fresh gum solution by means of a system including a supply tank including fresh gum solution, a waste tank for collecting the exhausted gum solution and the necessary pipes and pumps. The fresh gum solution may be produced automatically inside the processing apparatus by diluting a more concentrated solution with e.g. water. More preferred is to use a so-called ready-to use gum which can be used as such.

Because in the embodiment where the gum solution is used during just a limited period of time, only a negligible amount of sludge - such as salted-out compounds, precipitated or flocculated ingredients and/or other undissolved compounds - may be formed during the processing period between two (re)starts. Also, the level of dissolved ingredients and/or compounds present in the gum solution may be limited; i.e. the gum solution is not exhausted. As a result, not only the maintenance of the gumming units (as described below) becomes less burdensome, but also deposit on the exit and/or other rollers, and/or build-up on heater elements in the gumming unit is limited as well as possible adherance of sludge on the printing plate which may impair the images formed thereon; e.g. accept ink in the non-image areas.

In the context of this invention, a low amount of gum solution refers to for example a volume below 50 I e.g. between 1 and 40 I, preferably between 2 and 30 I, more preferably between 5 and 20 I and most preferably between 8 and 15 I. The volume refers to the amount of gum/development solution present in the gumming units, i.e. excluding the volume that may be present in the regeneration system, in the recirculation system and in any supply and waste collector tanks.

### FLAT BRUSHES

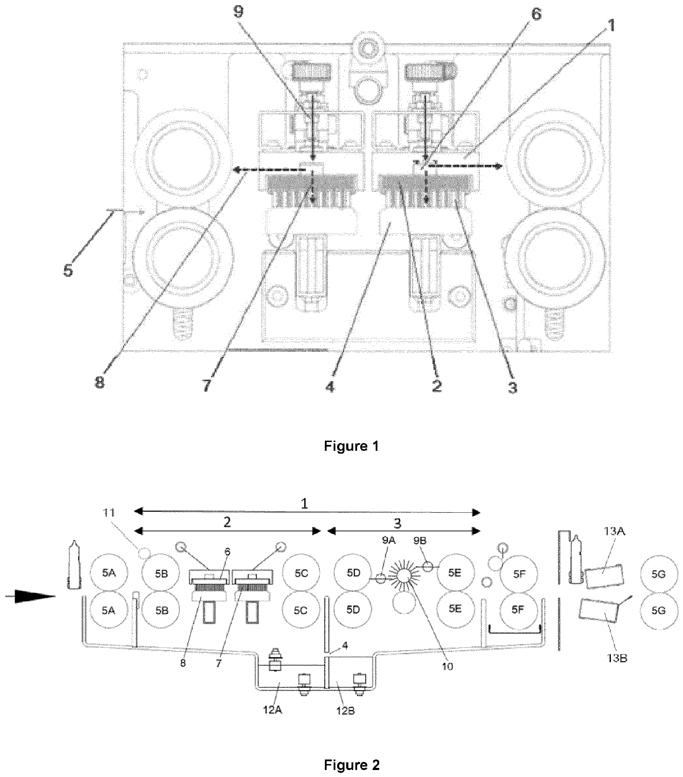

The flat brush(es) preferably comprise a movable structure (Fig. 1, 1) and a substantially flat support (Fig. 1, 2) attached to this movable structure. The flat brush(es) are capable of moving in a horizontal, linear way over the surface of the printing plate precursor by conversion of a rotary motion of a DC motor into a linear movement by means of a double crankshaft. The flat brush(es) is rubbing and/or brushing the printing plate precursor by moving back and forth in a direction preferably perpendicular or substantially perpendicular to the conveying direction of the printing plate precursor through the processor. In the embodiment where more than one flat brush is present, the shafts of the flat brushes are preferably interconnected by means of a connection plate. When the DC motor is making one full revolution, the flat brush(es) moves in a lineair way in one direction (= one stroke) followed by the opposite direction (= one stroke). Rubbing and/or brushing is preferably realized with the controller of the DC motor set between about 50 and 120 rpm corresponding to 100 to 240 strokes, more prefrerably between about 60 and 100 rpm corresponding to 120 to 200 strokes and most preferably between about 75 and 85 rpm corresponding to 150 to 170 strokes.

The substantially flat support preferably includes a plurality of sub-brushes (Fig. 1, 3) which are each composed of a set of bristles attached to said substantially flat support.

The sets of bristles are preferably attached to the substantially flat support in at least one axis either transverse or parallel to the axis along which the printing plate precursors are to be conveyed. The sets of bristles of said sub-brushes preferably have an implant diameter of 0.5 to 25 mm, more preferably 1 to 15 mm and most preferably 2 to 10 mm and are preferably independently angled 50-90 degrees, more preferably 70-85 degrees, and most preferably 80-85 degrees, relative to the substantially flat support. Preferably, at least half of the sets of bristles of said sub-brushes are angled. The bristles are made of any suitable material such as a polyamide based synthetic fiber (e.g. Nylon^{™}), a polyester based synthetic fiber (e. g. polyethylene terephthalate or polybutylene terephthalate), a polyacrylic synthetic fiber (e.g. polyacrylonitrile or polyalkyl-(meth)acrylate), polyvinylchloride, polyvinylidene chloride, cellulose, polyurethane, fluorinated resins (e.g. copolymers of ethylene/ethylene tetrafluoride, polyvinylidene fluoride), polystyrene, polyolefines such as polypropylene or polyethylene (e.g. HDPE) and/or natural fibres such as for example horse or boar hair, or Sisal^{™}. Most preferred, the bristles are made of Nylon^{™} or polypropylene. The bristles preferably have a bristle diameter of 0.02 to 1.0 mm, more preferably 0.04 to 0.5 mm and most preferably 0.06 to 0.2 mm. The bistle diameter is not especially restricted, but a diameter smaller than 0.01 mm may have inferior rubbing/brushing properties and a diameter thicker than 1 mm may scratch the printing plate precursor. The length of the bristles is preferably 2 to 50 mm, more preferably 4 to 25 mm and most preferably 6 to 20 mm. The length is not especially restricted but a length shorter than 3 mm may touch the printing plate precursor in a non uniform way.

The flat brush(es) is preferably present over the total width of the processor and is thus preferably adapted to the size of the processor. Preferably, the flat brush(es) have a length of preferably 300 to 2000 mm, more preferably 400 to 1500 mm and most preferably 500 to 1200 mm and a width of 10 to 200 mm, more preferably 15 to 150 mm and most preferably 25 to 100 mm. Due to the design of the flat brush(es) the contact area between the brush and the printing plate precursor is significantly higher compared to for example round brushes used in the prior art, resulting in an improved cleaning behaviour.

The bristles of the brush(es) (nearly) touch a support plate (Fig. 1, 4) - referred to herein as "brush support plate" which is provided opposite to the flat brush(es) and allows the printing plate precursor to pass in between the brush(es) and the brush support plate (Fig. 1, 5). Nearly means that the bristles of the brush(es) may contact the support plate or may be just above the support plate

The contact-pressure of the flat brush(es) to the printing plate precursor should be as uniform as possible all over its width in order to obtain a full clean out of the image areas. This can be achieved by for example adjusting optional screws present on top of the brush(es) and/or by adjusting the height of the brush support plate of the brush(es).

The brush support plate is preferably made of a material which substantially prevents scratches on the back of the printing plate precursor. Examples of suitable materials include polyamide, a polyester, polyacrylonitrile, polyalkyl-(meth)acrylate), polyvinylchloride, polyvinylidene chloride, cellulose, polyurethane, polystyrene, polyolefines such as polypropylene or polyethylene (e.g. HDPE, LDPE, MDPE). The brush support plate is preferably made of polyethylene. To prevent the so-called vacuum effect - i.e. sticking of the printing plate precursor to the brush support plate due to for example the weight of the brush(es) - preferably a fine pattern is provided onto the surface of the brush support plate. In addition, more pronounced grooves such as for example double grooves, zigzag patterned grooves etc may be applied onto the surface of the brush support plate in order to be able to drain a potential excess of gum solution.

The substantially flat support preferably comprises on top a cavity including a reservoir - also referred to as "brush chamber" - for holding gum solution (Fig. 1, 6). Gum solution is preferably injected via the gum supply (Fig. 1, 9) into the brush chamber in the cavity of the substantially flat support of the brush(es) whereby it becomes distributed in the brush chamber over the full brush length. The bottom of the brush chamber preferably includes nozzles (Fig. 1, 7) distributed over the full length of the flat brush(es). Also the sidewalls of the brush chamber facing the entry and/or exit feeding roller pairs preferably include nozzles (Fig. 1, 8). Via the nozzles present in the bottom of the brush chamber, gum solution can be provided between the bristles onto the surface of the printing plate precursor as it passes through the areas with the flat brushes. In addition, gum solution can be provided onto the feeding roller pairs via horizontal spraying through the optional nozzles present in the sidewalls of the brush chamber.

In a preferred embodiment, the first gumming unit includes at least two flat brushes which preferably rub and/or brush the plate precursor by moving back and forth in a direction preferably perpendicular or substantially perpendicular to the plate conveying direction through the processor. The back and forth movements may be in parallel or may be alternating i.e. when one brush is moving to the left, the other brush is moving to the right and vice versa. An alternating movement is preferred as lateral friction of the brushes on the plate may be reduced resulting in neutralization of possible skewing of the printing plate precursor as it passes through the areas with the flat brushes. Also, due to the lateral brush movement, so-called shooting of plates is no longer possible. The stroke distance between the two flat brushes may be zero or more than zero such as for example 10 mm or more than 10 mm, preferably 15 mm to 100 mm, more preferably 20 mm to 80 mm and most preferably 30 mm to 60 mm. Alternatively, the brushes are rubbing the printing plate precursor by an oscillating movement on the surface of the printing plate to be treated. The oscilating movement may be obtained by moving the brushes in two directions i.e. back and forth and preferably perpendicular or substantially perpendicular to the plate conveying direction.

### REGENERATION OF GUM SOLUTION

The activity level of the first and/or second gum solution may be regeneratied by adding water, a replenishment solution or optionally diluted fresh gum solution, or a mixture thereof. Adding optionally diluted fresh gum solution is preferred. Keeping the volume of gum solution constant by for example adding water and/or replenishment solution is also referred to in the art as top-up the gum solution.

A concentrated solution can be added as replenishment solution when the concentration of active products is under a desired level in the gum solution. A diluted gum solution or water can be used when the concentration of active products is above a desired level in the gum solution and/or when the viscosity of the gum solution is increased or when the volume of the gum solution is under a desired level, e.g. due to evaporation of solvent or water.

The regenerator liquids may be added to the first and/or second gum solution. The amount of regenerator added to the first gum solution may be restricted so as to compensate only for the volume which is drained to waste and/or dragged out with the plates. The amount of regenerator added to the second gum solution is preferably adjusted to compensate for the degradation of the gum solution.

It is preferred that the amount of replenishment and/or gum solution added for the regeneration of gum solution, is small in order to limit the amount of waste produced during processing. Therefore, the rate of regeneration - depending on the concentration of the replenishment/gum solution - is preferably between 1 ml and 100 ml per m² of treated plates, more preferably between 2 ml/m² and 85 ml/m², more preferably between 4 ml/m² and 60 ml/m² and most preferably between 5 ml/m² and 30 ml/m². The regenerator is preferably added to the second gum solution.

By using small amounts of gum solution for a limited period in time, little replenishment is required to keep the activity of the first gum solution at a sufficient level and/or constant. Therefore, the embodiment wherein a small volume of gum solution is used generates, compared to development of the prior art where large amounts of gum solutions for a longer period in time are used, less waste. Indeed, the waste - including the amount of drained gum solution and the amount of applied replenisher - generated during said limited period in time, is less compared to the waste that would have been generated when the gum solution would have been carried out during a longer period in time.

The regenerator liquids can be added continuously or in batches when the activity of the gum solution becomes too low and/or to keep the activity level constant. The activity level of the gum solutions can be determined by monitoring e.g. pH, density, conductivity, viscosity, the number and/or area (square meters) of processed plates processed since a (re)start with fresh solution and/or the time lapsed since a (re)start with fresh solution. When the addition of regenerator is regulated by measurement of one of these parameters, the regenerator liquid can be added when a predetermined threshold value of that parameter is reached or is crossed. The amount of regenerator added each time depends on the predetermined threshold value. For example, when the measured parameter is the number of square meters of plate material processed, a predetermined amount of replenishment is added each time after processing a predetermined area of printing plate precuror. As a further example, the measured parameter can be the conductivity or conductivity increase of the solution monitored with a conductivity meter. Beyond a defined conductivity value, regenerator liquid can automatically be added to the development solution.

The apparatus according to the present invention preferably includes means for or adapted to monitor the activity level of the gum solution as described above.

The first gumming unit preferably contains an overflow pipe which drains the gum solution into a collector tank. The drained gum solution may be purified and/or regenerated by e.g. filtration, decantation or centrifugation and then reused, however, the drained gum solution is preferably collected for disposal.

### (RE)CIRCULATION OF GUM SOLUTUTION

The first and/or second gum solutions are preferably (re)circulated, more preferably independently from one another e.g. by means of a circulation pump. The first and second gum solutions are kept in respectively two baths or sumps from which they may be recirculated along a closed loop into for example spray bars which supply the gum solution to the printing plate precursor. More preferably, the gum solution is recirculated via the nozzles present in the bottom of the brush chamber of the flat brush(es) present in the first gumming unit and/or via the nozzles present in the sidewalls of the brush chamber facing the entry and/or exit feeding roller pairs. The gum solutions then flow back into the respective sumps.

Preferably, a filter is present in the (re)circulation system, e.g. in the pipes, which is capable of any kind of sludge and/or dissolved ingredients from the gum solutions.

During recirculation, the gum solution is preferably at least partly removed (sucked) from the gumming unit and may then be injected through at least one inlet opening formed in for example the sidewall of the gumming unit back into the gumming unit thereby circulating and stirring the gum solution. More preferably, the gum solution which is sucked away is injected through at least one inlet opening in the gumming unit near the exit roller pair. Even more preferably, the gum solution which is sucked away is injected through at least one inlet opening formed in the cover plate of the gumming unit. Most preferably, the gum solution which is sucked away is injected through at least one spray bar which is preferably positioned in the gumming unit near the exit roller pair, more preferably parallel to the exit rollers. The gum solution is preferably at least partly sucked in from the area under and/or near the exit rollers in the gumming unit. Preferably, a filter is present in the circulation system, e.g. in the pipes, which is capable of removing sludge and/or dissolved ingredients from the gum solution.

### GUM SOLUTION

The composition of the gum solution described hereafter refers to the fresh gum solution that is used for a (re)start. Preferably, the same gum solution is used for the (re)start in both units of the gumming section. Such fresh gum solution may be obtained as a ready-to-use solution or by diluting a more concentrated solution that is supplied by the manufacturer. The dilution of a gum concentrate may be done in a separate apparatus or may be integrated in the processing apparatus. In alternative embodiments, a (re)start may involve filling the first and second gumming unit with different gum solutions, e.g. different concentrations obtained by a different dilution of the same gum solution.

Suitable gum solutions, to be used as fresh gum solution in the present invention, are aqueous liquids which comprise one or more surface protective compounds that are capable of protecting the lithographic image of a printing plate against contamination, oxidation or damaging. Suitable examples of such compounds are film-forming hydrophilic polymers or surfactants. The layer that remains on the plate after treatment with the gum solution in the second gumming step and drying preferably comprises between 0.1 and 20 g/m² of the surface protective compound. This layer typically remains on the plate until the plate is mounted on the press and is removed by the ink and/or fountain when the press run has been started. The gum solutions preferably have a pH below 11, more preferably below 9, even more preferably a pH from 0 to 8, and most preferably from 1 to 6. Suitable gum solutions used herein have a pH around 2, 5 or 7. More details of solutions suitable as fresh gum solution for use in the present invention are described in for example EP 1 342 568 ([0008] to [0021])and WO 2005/111727 (page 6 line 5 till page 11 line 30).

A solution of a surfactant and/or a solution of a buffer can be added when the gum solution needs a higher concentration of a surfactant or when the pH of the gum solution needs to be controlled at a desired pH value or at a desired pH value in a range of two pH values, e.g. between 1 and 9.

### PROCESSING APPARATUS

The present invention also provides an apparatus which is especially designed for performing the processing methods of the present invention. Figure 2 represent a highly preferred embodiment of such a processing apparatus, which includes a development/gumming section (Fig 2: 1) comprising two gumming units (Fig 2: 2,3) mutually connected by a cascade (Fig 2: 4) which allows overflow of liquid from the second gumming unit into the first gumming unit. Additional gumming units may be used, but the preferred embodiments comprise only two gumming units.

The processing apparatus preferably comprises at least two roller pairs (Fig 2:5A and 5F) - also referred to as nip or feeder rollers - which convey the plates into and out of the processing apparatus. The processing apparatus preferably comprises a cover plate to shield the apparatus from the air.

Well known features which are preferably present in the the apparatus but not shown in Figure 2 are : a feeder for delivering plates one by one to the development/gumming section; a (re)circulation and/or regeneration system including well known elements such as a supply tank for replenishment solution, a pump and the necessary pipes to supply the regenerator liquid to the gumming unit; supply tanks comprising fresh gum solution, or one or more replenishing solutions; waste collector tanks wherein exhausted gum solution is drained; a water tank to dilute concentrated chemistry; and other conventional parts.

When the description below refers to the plate precursor which during the operation of the apparatus travels through the various sections, it is assumed that the plate is facing upwards, i.e. with the heat- or light-sensitive coating facing upwards (the other side of the plate is referred to as "backside"). However, embodiments wherein the plate is facing downwards are equally within the scope of the present invention.

### GUMMING UNITS

The printing plate precursor enters the first gumming unit of the development/gumming section via the entry roller pair (Fig 2: 5B) and leaves it via exit roller pair (Fig 2: 5 After entry into the first development/gumming unit, the printing plate precursor moves along the flat brushes (Fig 2: 6), more precisely between the bristles of the brushes (Fig 2: 7) and the brush support plate (Fig 2: 8) - as described in detail above. During transport of the printing plate precursor in the first development/gumming unit, gum solution is supplied to the surface of the precursor. In a preferred embodiment, gum solution which is distributed over the full brush width via the brush chamber (Fig 1: 6; see above), is provided onto the surface of the printing plate precursor via the nozzles provided in the flat brushes in between the bristles. In addition, preferably the sidewalls of the brushes which face the feeding roller pairs (Fig 2: 5B and 5C) also include nozzles. These nozzles in the sidewalls are able to spray gum solution onto these feeding roller pairs via horizontal spraying.

The printing plate precursor subsequently enters the second development/gumming unit of the development/gumming section via the entry roller pair (Fig 2, 5D) and leaves it via exit roller pair (Fig 2, 5E). In the second development/gumming unit, preferably two spray bars are provided: one bar (Fig 2: 9A) which is capable of spraying gum both onto the nip of the roller pair (Fig 2: 5D) and onto the round rotating brush (Fig 2: 10), and one bar (Fig 2: 9B) which sprays gum towards the nip of the roller pair (Fig 2: 5E). The bar (Fig 2: 9B) spraying gum to the nip of the roller pair (Fig 2: 5E) preferably contains at least one row of holes and is capable of keeping the nip rollers wet and providing a finishing layer onto the surface of the plate. The bar (Fig 2: 9A) capable of spraying gum both onto the roller and the round rotating brush preferably contains at least two rows of holes. Preferably, the bar(s) for spraying the second gum solution are in a so-called jog-mode, i.e. gum is provided on a regular basis even when no plate is present in the development/gumming unit in order to prevent stickyness of the nip rollers and/or brush. Preferably, the nip rollers are engaged on a regular basis; even when no plate passes.

In the preferred embodiment of Figure 2, the nip rollers (Fig 2: 5B, 5C) of the first development/gumming unit are provided with a scavenger roller (Fig 2: 11) to prevent contamination of first gum into the second development/gumming unit.

The second gum solution is preferably regenerated by means of an inlet that supplies regenerator liquid, which may be water, optionally diluted fresh gum and/or replenishment solution, to the second development/gumming unit, e.g. to the second gum sump (Fig 2: 12B). The first gum sump (Fig.2: 12A) includes includes an overflow pipe which drains the gum solution into a collector tank.

Other well known elements of the regenerator system are not shown in the Figures, such as a supply tank for holding fresh gum solution, water or replenishment solution; a pump and the necessary pipes to supply the regenerator liquid to the second development/gumming unit. Also the first gum solution may be regenerated, either by the same or an analogous regeneration system as used for the second gum solution. The first gum solution may also be regenerated by actively pumping gum solution from the second to the first development/gumming unit.

### SUPPLY OF GUM SOLUTION BY NOZZLES

Alternatively, gum solution may be applied to the printing plate precursor by spraying or jetting, preferably by means of spray or (valve) jet nozzles by means of one or more a spray bars. Depositing of gum solution onto the printing plate precursor may be in accordance with the plate area or even with the image data of the plate, as described in EP 2 775 351.

In the embodiment where the gum solution is applied onto the printing plate precursor by means of nozzles which spray or jet a flow of gum on the surface of the plate, the nozzles may be configured as an array of nozzles, e.g. an array of holes in a spray bar or an array of jet nozzles in an inkjet head, e.g. a valve-jet head.

In that embodiment, the nozzles may be integrated in a sidewall or in both sidewalls of the development/gumming unit so as to discharge gum solution transversely over the coating of the plate. In the alternative, the nozzles may be present in the bottom or the cover plate, depending which of both is facing the image recording layer of the printing plate. Combined embodiments wherein nozzles are integrated in one or both sidewalls as well as in the bottom and/or the cover plate are also within the scope of this invention.

The gum solution may be supplied by the nozzles as a pressurized flow over the surface area of the plate such that successive target areas of the plate are dynamically and uniformly flooded with gum solution. The nozzle streams of gum solution can be tuned with respect to direction, shape, overlap, and surface turbulence. Although the plate target area preferably experiences a continuous turbulent flooding, the supply through the nozzles can also be applied in consecutive pulses. Dissolution of the soluble coating regions is thereby achieved quickly and uniformly by providing a flow of gum solution which causes turbulence and which is constantly displaced and replaced.

More details concerning suitable nozzles can be found in EP 2 775 351 (for example [0034] to [0049]).

### DRYING SECTION

After the final gum has been applied, the printing plate precursor is preferably not rinsed but immediately conveyed to a drying section which is preferably integrated into the apparatus. Drying can be achieved by drying means (Fig 2: 13A and 13B) emitting hot air, infrared and/or microwave radiation, and other methods generally known in the art. The printing plate precursor may then be mounted on the plate cylinder of a printing press and the printing process may be started.

### THE LITHOGRAPHIC PRINTING PLATE PRECURSOR

The lithographic printing plate precursor according to the present invention is negative-working, i.e. after exposure and development the non-exposed areas of the coating are removed from the support and define hydrophilic (non-printing) areas, whereas the exposed coating is not removed from the support and defines oleophilic (printing) areas. The hydrophilic areas are defined by the support which has a hydrophilic surface or is provided with a hydrophilic layer. The hydrophobic areas are defined by the coating, hardened upon exposing, optionally followed by a heating step. Areas having hydrophilic properties means areas having a higher affinity for an aqueous solution than for an (oleophilic) ink; areas having hydrophobic properties means areas having a higher affinity for an (oleophilic) ink than for an aqueous solution.

"Hardened" means that the coating becomes insoluble or non-dispersible in the developing solution and may be achieved through polymerization and/or crosslinking of the photosensitive coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

The coating contains a toplayer and at least one layer including a photopolymerisable composition, said layer is also referred to as the "photopolymerisable layer". The toplayer is provided on top of the photopolymerisable layer. The coating may further include other layers such as for example an intermediate layer, located between the support and the photopolymerisable layer and/or between the top layer and the photopolymerisable layer, an adhesion improving layer, a hydrophilizing layer and/or other layers.

The printing plate of the present invention is characterized in that it can be exposed at a low energy density, i.e. below 190 mJ/m²; preferably between 70 and 190 mJ/m²; more preferably between 75 and 150 mJ/m² and most preferably between 80 and 120 mJ/m².

### POLYMERISABLE COMPOUND

The photopolymerisable layer includes at least one polymerisable compound and optionally a binder. The photopolymerisable layer has a coating thickness preferably ranging between 0.2 and 5.0 g/m2, more preferably between 0.4 and 3.0 g/m2, most preferably between 0.6 and 2.2 g/m2.

According to a preferred embodiment of the present invention, the polymerisable compound is a polymerisable monomer or oligomer including at least one terminal ethylenic unsaturated group, hereinafter also referred to as "free-radical polymerisable monomer". The polymerisation involves the linking together of the free-radical polymerisable monomers. Suitable free-radical polymerisable monomers include, for example, mono- or multifunctional (meth)acrylate monomers (such as (meth)acrylate esters of ethylene glycol, trimethylolpropane, pentaerythritol, ethylene glycol, ethoxylated trimethylolpropane, urethane (meth)acrylate) and oligomeric amine diacrylates. The (meth)acrylic monomers may also have other ethylenically unsaturated groups or epoxide groups in addition to the (meth)acrylate group. The (meth)acrylate monomers may also contain an acidic (such as a carboxylic acid or phosphoric acid) or basic (such as an amine) functionality.

Suitable free-radical polymerisable monomers are disclosed in [0042] and [0050] of EP 2 916 171.

### THE INITIATOR

Any free radical initiator capable of generating free radicals upon exposure directly or in the presence of a sensitizer, is according to this invention a suitable initiator. Suitable examples of initiators include onium salts, carbon-halogen bond-containing compounds such as [1,3,5] triazines having trihalomethyl groups, organic peroxides, aromatic ketones, thio compounds, azo based polymerization initiators, azide compounds, ketooxime esters, hexaarylbisimidazoles, metallocenes, active ester compounds, borates and quinonediazides. Of these, onium salts, especially iodonium and/or sulfonium salts are preferable in view of storage stability.

More specific suitable free-radical initiators include, for example, the derivatives of acetophenone (such as 2,2-dimethoxy-2-phenylacetophenone, and 2-methyl-l-[4-(methylthio) phenyll-2-morpholino propan-l-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-l-yl)-s-triazine, 2,4-bis(trichloromethyl)-6-piperonyl-s- triazine, and 2,4-bis(trichloromethyl)-6-[(4 - ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha.9-2,4-cyclopentadien-1-yl) bis[2,6-difluoro-3-(IH-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines. These initiators may be used alone or in combination.

Optionally substituted trihaloalkyl sulfones wherein halo independently represents bromo, chloro or iodo and sulfone is a chemical compound containing a sulfonyl functional group attached to two carbon atoms, are particularly preferred initiators. Tribromomethyl phenyl sulfones are most preferred initiators. More details concerning this initiator can be found in WO2019/179995 paragraphs [0029] to [0040].

The amount of the initiator typically ranges from 0.1 to 30 % by weight, preferably from 0.5 to 15 % by weight, most preferably from 2 to 10 % by weight relative to the total weight of the non volatile components of the photopolymerisable composition.

A very high sensitivity can be obtained by the combination of an optical brightener as sensitizer and a polymerisation initiator.

The photopolymerisable layer may also comprise a co-initiator. Typically, a co-initiator is used in combination with a free radical initiator. Suitable co-initiators for use in the photopolymer coating are disclosed in US 6,410,205; US 5,049,479; EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161. Specific co-initiators, as described in EP 107 792, may be present in the photopolymerizable layer to further increase the sensitivity. Preferred co-initiators are disclosed in EP 2 916 171 [0051] and are incorporated herein by reference.

A very high sensitivity can be obtained by including a sensitizer such as for example an optical brightener in the coating. Suitable examples of optical brighteners as sensitizers are described in WO 2005/109103 page 24, line 20 to page 39. Useful sensitizers can be selected from the sensitizing dyes disclosed in US 6,410,205; US 5,049,479; EP 1 079 276, EP 1 369 232, EP 1 369 231, EP 1 341 040, US 2003/0124460, EP 1 241 002 and EP 1 288 720.

Specific co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole, 2-mercapto-benzimidazole, 4-methyl-3-propyl-1,2,4-triazoline-5-thione, 4-methyl-3-n-heptyl-1,2,4-triazoline-5-thione, 4-phenyl-3-n-heptyl-1,2,4-triazoline-5-thione, 4-phenyl-3,5-dimercapto-1,2,4-triazole, 4-n-decyl-3,5-dimercapto-1,2,4-triazole, 5-phenyl-2-mercapto-1,3,4-oxadiazole, 5-methylthio-1,3,4-thiadiazoline-2-thione, 5-hexylthio-1,3,4-thiadiazoline-2-thione, mercaptophenyltetrazole, pentaerythritol mercaptopropionate, butyric acid-3-mercapto-neopentanetetrayl ester, pentaerythritol tetra(thioglycolate). Other preferred co-initiators are polythioles as disclosed in WO 2006/048443 and WO 2006/048445. These polythiols may be used in combination with the above described thiols, e.g. 2-mercaptobenzothiazole.

The photopolymerizable layer may optionally include violet or infrared light absorbing dyes as sensitizers. Infrared light absorbing dyes absorb light between 750 nm and 1300 nm, preferably between 780 nm and 1200 nm, more preferably between 800 nm and 1100 nm. Particular preferred sensitizers are heptamethinecyanine dyes disclosed in EP 1 359 008 paragraph [0030] to [0032].

### THE BINDER

The photopolymerizable layer preferably includes a binder. The binder can be selected from a wide series of organic polymers. Compositions of different binders can also be used. Useful binders are described in for example EP 1 043 627 in paragraph [0013], WO2005/111727 page 17 line 21 to page 19 line 30 and in WO2005/029187 page 16 line 26 to page 18 line 11.

The photopolymerizable layer may include discrete particles, i.e. particulate shaped polymers including homopolymers or copolymers prepared from monomers such as ethylene, styrene, vinyl chloride, methyl acrylate, ethyl acrylate, methyl methacrylate, ethyl methacrylate, acrylonitrile, vinyl carbazole, acrylate or methacrylate, or mixtures thereof. Preferably the discrete particles are particles which are suspended in the polymerisable composition. The presence of discrete particles tends to promote developability of the unexposed areas.

Thermally reactive polymer fine particles including a thermally reactive group such as an ethylenically unsaturated group, a cationic polymerizable group, an isocyanate group, an epoxy group, a vinyloxy group, and a functional group having an active hydrogen atom, a carboxy group, a hydroxy group, an amino group or an acid anhydride.

Specific examples of the polymeric binders according to this embodiment are described in US 6,899,994; US 2004/0260050, US 2005/0003285, US 2005/0170286, US 2005/0123853 and EP 2 916 171 in [0029], [0030] and [0031]. Other suitable binders as described in EP 2 471 655, EP 2 492 748 and EP 2 660 068 include multifunctional thiols having 6 to 10 functional groups as a nucleus (central skeleton) and polymer chains connected to the nucleus through sulfide bonds. In addition to the polymeric binder of this embodiment the imageable layer may optionally comprise one or more co-binders. Typical co-binders are water-soluble or water-dispersible polymers, such as, cellulose derivatives, polyvinylalcohol, polyacrylic acid poly(meth)acrylic acid, polyvinylpyrrolidone, polylactide, polyvinylphosphonic acid, synthetic co-polymers, such as co-polymers of an alkoxy polyethylene glycol (meth)acrylate. Specific examples of co-binders are described in US 2004/0260050, US 2005/0003285 and US 2005/0123853. Printing plate precursors, the imageable layer of which comprises a binder and optionally a co-binder according this embodiment and described in more detail in US 2004/0260050, US 2005/0003285 and US 2005/0123853.

The average particle diameter of the polymer fine particle is preferably 0.01 mm to 3.0 mm. Particulate polymers in the form of microcapsules, microgels or reactive microgels are suitable as disclosed in EP 1 132 200; EP 1 724 112 and US 2004/106060.

### OTHER INGREDIENTS

The photopolymerisable layer may also comprise particles which increase the resistance of the coating against manual or mechanical damage. The particles may be inorganic particles, organic particles or fillers such as described in for example US 7,108,956. More details of suitable spacer particles described in EP 2 916 171 [0053] to [0056] are incorporated herein by reference.

The photopolymerizable layer may also comprise an inhibitor. Particular inhibitors for use in the photopolymer coating are disclosed in US 6,410,205, EP 1 288 720 and EP 1 749 240.

The photopolymerizable layer may further comprise an adhesion promoting compound. The adhesion promoting compound is a compound capable of interacting with the support, preferably a compound having an addition-polymerizable ethylenically unsaturated bond and a functional group capable of interacting with the support. Under "interacting" is understood each type of physical and/or chemical reaction or process whereby, between the functional group and the support, a bond is formed which can be a covalent bond, an ionic bond, a complex bond, a coordinate bond or a hydrogen-bond, and which can be formed by an adsorption process, a chemical reaction, an acid-base reaction, a complex-forming reaction or a reaction of a chelating group or a ligand. The adhesion promoting compounds described in EP 2 916 171 [0058] are suitable examples.

Various surfactants may be added into the photopolymerisable layer to allow or enhance the developability of the precursor; especially developing with a gum solution. Both polymeric and small molecule surfactants for example nonionic surfactants are preferred. More details are described in EP 2 916 171 [0059].

### TOPLAYER

The coating preferably includes a toplayer or protective overcoat layer which may act as an oxygen barrier layer. Low molecular weight substances present in the air may deteriorate or even inhibit image formation and therefore a toplayer is applied to the coating. A toplayer should preferably be easily removable during development, adhere sufficiently to the photopolymerisable layer or optional other layers of the coating and should preferably not inhibit the transmission of light during exposure. The toplayer is preferably provided on top of the photopolymerisable layer.

The toplayer preferably includes a binder. Preferred binders which can be used in the toplayer are polyvinyl alcohol or polyvinylalcohol/polyvinyl acetate copolymers. Polyvinylalcohol is preferred and has preferably a hydrolysis degree ranging between 74 mol % and 99 mol %, more preferably between 80-98%. The weight average molecular weight of the polyvinylalcohol can be measured by the viscosity of an aqueous solution, 4 % by weight, at 20°C as defined in DIN 53 015, and this viscosity number ranges preferably between 2 and 26, more preferably between 2 and 15, most preferably between 2 and 10.

The toplayer may further include a hydrophobic binder such as a halogenated polymer which includes at least one halogen. More details concerning the hydrophobic binder can be found in EP 3 587 113 in [0026] to [0039].

The coating thickness of the toplayer is between 0.10 and 1.75 g/m², preferably between 0.20 and 1.30 g/m², more preferably between 0.25 and 1.0 g/m² and most preferably between 0.30 and 0.80 g/m². In a more preferred embodiment of the present invention, the toplayer has a coating thickness between 0.25 and 1.75 g/m² and comprises a polyvinylalcohol having a hydrolysis degree ranging between 74 mol % and 99 mol % and a viscosity number as defined above ranging between 3 and 26.

The toplayer preferably further includes an infrared absorbing dye which is capable of forming a coloured compound - whereby a print-out image is formed - upon exposure to infrared light and/or heat. The infrared absorbing dye preferably has a main absorption in the infrared wavelength range of the electromagnetic spectrum - i.e. a wavelength range between about 750 and 1500nm - and does preferably not have a substantial light absorption in the visible wavelength range of the electromagnetic spectrum - i.e. a wavelength range between 390 and 700nm. The thermochromic dye preferably includes at least one thermocleavable group which is transformed by a chemical reaction, induced by exposure to IR radiation or heat, into a group which is a stronger electron-donor. As a result, the exposed thermochromic IR dye absorbs substantially more light in the visible wavelength range of the electromagnetic spectrum, or in other words, the thermochromic dye undergoes a hypsochromic shift whereby a visible image is formed, also referred to as print-out image. The concentration of the thermochromic IR dyes with respect to the total dry weight of the coating, may be from 0.1 %wt to 20.0 %wt, more preferably from 0.5 %wt to 15.0 %wt, most preferred from 1.0 %wt to 10.0 %wt. Preferred thermochromic IR dyes are described in WO2019/219560 in [0029] to [0040].

The toplayer may optionally include other ingredients such as inorganic acids such as HCL, HBr, HI, HF, sulphuric acid, nitric acid or phosphoric acid; organic acids such as aliphatic or aromatic hydrocarbons having one or more acid groups as described in WO2021/204502 [0024] to [0028]; nitrite/nitrate; matting agents; polymers including 3 to 10 chains branched from a central skeleton; wetting agents such as for example alkylene glycol, dialkylene glycol, glycerin, trimethylol propane and diglycerin; surfactants such as anionic surfactants such as sodium alkyl sulphate or sodium alkyl sulphonate; amphoteric surfactants such as alkylaminocarboxylate and alkylamino-dicarboxylate; non-ionic surfactants such as polyoxyethylene alkyl phenyl ether, (co)polymers comprising siloxane and/or perfluoroalkyl units and/or oligo(alkylene oxide) units; alkoxylated alkylene diamines; alkoxylated alkanols, phosphoric acid alkyl esters, phosphonic acid alkyl esters; leuco dyes as described in EP 3 587 113 [0040] to [0057]; fillers, (organic) waxes; cellulose; alkoxylated alkylene diamines as for example disclosed in EP 1 085 380 (paragraph [0021] and [0022]), glycerine, inorganic particles particles such as silicon or titanium dioxide particles, natural or synthetic micas ; pigments; wetting agents such as for example alkylene glycol, dialkylene glycol, glycerin, trimethylol propane and diglycerin. antiseptic agents and/or ink receptivity agents.

### SUPPORT

The lithographic printing plate used in the present invention comprises a support which has a hydrophilic surface or which is provided with a hydrophilic layer. The support is preferably a grained and anodized aluminium support, well known in the art. Suitable supports are for example disclosed in EP 1 843 203 (paragraphs [0066] to [0075]). The surface roughness, obtained after the graining step, is often expressed as arithmetical mean center-line roughness Ra (ISO 4287/1 or DIN 4762) and may vary between 0.05 and 1.5 µm. The aluminum substrate of the current invention has preferably an Ra value between 0.1 and 1.4 µm, more preferably between 0.3 and 1.0 µm and most preferably between 0.4 and 0.9 µm. The lower limit of the Ra value is preferably about 0.1 µm. More details concerning the preferred Ra values of the surface of the grained and anodized aluminum support are described in EP 1 356 926. By anodising the aluminum support, an Al₂O₃ layer is formed and the anodic weight (g/m² Al₂O₃ formed on the aluminum surface) varies between 1 and 8 g/m². The anodic weight is preferably ≥ 2.0 g/m², more preferably ≥ 2.5 g/m² and most preferably ≥ 3.0 g/m².

The grained and anodized aluminium support may be subjected to so-called post-anodic treatments, for example a treatment with polyvinylphosphonic acid or derivatives thereof, a treatment with polyacrylic acid or derivatives thereof, a treatment with potassium fluorozirconate or a phosphate, a treatment with an alkali metal silicate, or combinations thereof. Enlargement or sealing of micropores of the anodized aluminum as disclosed in JP2001-253181A or JP2001-322365A may be performed. Treatment of the edges of the support as described in for example US 2017/320351 may be of interest to prevent occurrence of printing edges. Alternatively, the support may be treated with an adhesion promoting compound such as those described in EP 1 788 434 in [0010] and in WO 2013/182328. However, for a precursor optimized to be used without a pre-heat step it is preferred to use a grained and anodized aluminium support without any post-anodic treatment.

Besides an aluminium support, a plastic support, for example a polyester support, provided with one or more hydrophilic layers as disclosed in for example EP 1 025 992 may also be used.

Any coating method can be used for applying two or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However, it is not necessary (and may not even be possible) to remove all the solvent in the drying step. Indeed, the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

### EXPOSURE STEP

The printing plate precursor is preferably image-wise exposed by a laser emitting IR light. Preferably, the image-wise exposing step is carried out off-press in a platesetter, i.e. an exposure apparatus suitable for image-wise exposing the precursor with a laser such as a laser diode, emitting around 830 nm or a Nd YAG laser emitting around 1060 nm, or a violet laser, emitting around 400 nm, or a gas laser such as an Ar laser, or with a digitally modulated UV-exposure set-up, using e.g. digital mirror devices, by a conventional exposure in contact with a mask. Preferably, the precursor is image-wise exposed by a laser emitting IR-light (i.e. wavelengths ranging between 750 and 1500 nm) or violet light (i.e. wavelengths ranging between 350 and 450 nm); most preferred by a laser emitting infrared light.

### PREHEAT STEP

After the exposing step, the precursor may be pre-heated in a preheating unit, preferably at a temperature of about 80°C to 150°C and preferably during a dwell time of about 5 seconds to 1 minute. This preheating unit may comprise a heating element, preferably an IR-lamp, an UV-lamp, heated air or a heated roll. Such a preheat step can be used for printing plate precursors comprising a photopolymerisable composition to enhance or to speed-up the polymerization and/or crosslinking reaction.

### Examples

### 1. Printing plate precursors

The commercial printing plate precursor Adamas^{™} available from Agfa Offset BV was stored for respectively one month and twelve months under normal storage conditions (e.g. below 25°C and 50% RH) resulting in respectively printing plate precursors PPP-01 and PPP-02. After this storage period, the printing plate precursors were exposed as described next.

### 2. Imaging

The obtained printing plate precursors PPP-01 and PPP-02 were subsequently imaged at 2400 dpi with an Avalon N8-90 thermal platesetter provided with a 340 Ipi Agfa Sublima Screening, commercially available from Agfa Offset BV and equipped with a 830 nm IR laser diode, at an energy density of 90 mJ/cm².

### 3. Processing

After imaging, both printing plate precursors PPP-01 and PPP-02 were subjected to processing with N02T Gum (pH = 8 at room temperature, commercially available from Agfa Offset BV) to remove the coating in the non-image areas from the support.

### 4. Clean out behaviour

### Dot reproduction

The clean out behaviour of the two printing plate precursors PPP-01 and PPP-02 was evaluated in terms of dot reproduction on plate with a Techkon Spectroplate device^{™}.

### Results for PPP-01

The readings on a nominal 50% raster tint of a 340 Ipi Sublima screening indicate a 2% dot area difference between the plate precursor processed with a circular brush and processed with a flat brush: the measured value of the 50% raster tint is 2% lower in case of processing PPP-01 with a processor equipped with a flat brush compared to processing the plate with a processor equipped with round circular brush. This difference of 2% dot area indicates that the clean out performance obtained with a processor equipped with a flat brush is better than the clean out performance obtained with a processor equipped with a round circular brush. This obtained 2% dot area difference may for example relate to the presence of unwanted non image residues around dots present on the processed printing plate.

Furthermore, the clean out result obtained with a processor equipped with a flat brush results in a more linear plate response compared to the clean out results obtained with a processor equipped with a circular brush. A linear plate response means that the nominal intended output value of a raster tint %, and the measured result of that same raster tint % on the printing plate, are about equal. In other words, a linear plate response means that the measured raster tint % on the printing plate corresponds to the real imaged dot coverage. A linear plate response is highly preferred in the market.

### Results for PPP-02

The clean out behaviour of the printing plate precursor PPP-02 which is an aged (ten months old) printing plate precursor, obtained by using a processor equipped with a round circular brush, is unacceptable and the dot reproduction could not be determined. The clean out of the printing plate precursor PPP-02 obtained with a processor equipped with a flat brush was excellent.

### Uniformity test

The clean out behaviour in terms of uniformity was evaluated for the two printing plate precursors PPP-01 and PPP-02. The uniformity is measured with a Techkon Spectroplate device and measures the variation in rastertint over the full width of the clean out device. An excellent uniformity illustrates a homogenous clean out and is typically in a range of +/- 1 % on a 40% rastertint in Sublima 340 Ipi.

The parameter used to evaluate clean out behaviour was a visual/microscopic evaluation of the positive and negative 1 and 2 pixel line reproduction on the printing plate. An unacceptable clean out is defined as a large difference between positive and negative pixel line width at right exposure, or when the negative pixel line is not reproduced.

The non image parts of a printing plate precursor which are perpendicular to the fast scan (modulation) direction of the processor are more difficult to clean compared to the slow scan (modulation) direction. The results showed that the performance of a processor equipped with a flat brush is better than that of a processor equipped with a round circular brush. This was observed in 1 pixel and 2 pixel line clean out results and in the balance between positive and negative lines. In addition, these results obtained with a processor equipped with a flat brush were less affected by the gum type, thus indicating a wider clean out latitude.

In conclusion, the results obtained for PPP-01 and PPP-02 processed with a processor including a circular brush were inferior compared to the uniformity results obtained with a processor including a flat brush.

## Claims

1. An apparatus for processing a lithographic printing plate precursor comprising a development/gumming section including a first and a second development/gumming unit which are connected by a cascade configuration which allows an overflow of liquid from the second development/gumming unit to the first development/gumming unit,
**characterized in that** the first development/gumming unit includes at least one flat brush.

2. The apparatus according to claim 1 wherein the at least one flat brush comprises a movable structure (Fig 1, 1) and a substantially flat support (Fig 1, 2) attached to this movable structure which includes a plurality of sub-brushes.

3. The apparatus according to claims 1 or 2 wherein the at least one flat brush is present over the total width of the apparatus for processing the printing plate precursor.

4. The apparatus according to any of the preceding claims wherein the at least one flat brush has a length of 300 to 2000 mm and a width of 10 to 200 mm.

5. The apparatus according to any of the preceding claims wherein the at least one flat brush is capable of rubbing and/or brushing the plate precursor by moving back and forth in a direction perpendicular or substantially perpendicular to the conveying direction of the printing plate precursor through the processor.

6. The apparatus according to any of the preceding claims wherein the substantially flat support includes a plurality of sub-brushes (Fig. 1, 3) which are each composed of a set of bristles attached to said substantially flat support.

7. The apparatus according to claim 6 wherein the sets of bristles of said sub-brushes have an implant diameter of 0.5 to 25 mm and are independently angled 50-90 degrees.

8. The apparatus according to any of the preceding claims 6 or 7 wherein he bristles of the brush(es) nearly touch a support plate (Fig. 1, 4) which is provided opposite to the flat brush(es) and allows the printing plate precursor to pass in between the brush(es) and said support plate.

9. The apparatus according to any of the preceding claims wherein the substantially flat support comprises at the top a cavity including a brush chamber (Fig 1, 6) for holding a liquid.

10. The apparatus according to claim 9 wherein the bottom of the brush chamber includes nozzles (Fig. 1, 7) which are distributed over the full length of the at least one flat brush and are capable of providing gum solution between the bristles onto the surface of the printing plate precursor.

11. The apparatus according to claims 9 or 10 wherein the first development/gumming unit comprises feeding roller pairs (Fig. 2: 11B and 11C) and wherein the sidewalls of the brush chamber facing said feeding roller pairs includes nozzles which are able to spray gum solution onto said feeding roller pairs via horizontal spraying.

12. The apparatus according to any of the preceding claims wherein the first development/gumming unit includes at least two flat brushes which are able to rub and/or brush the plate precursor by moving back and forth in a direction perpendicular or substantially perpendicular to the plate conveying direction through the processor wherein the back and forth movements are alternating.

13. A method for processing a lithographic printing plate precursor with an apparatus according to any of claims 1 to 12, the method comprising the steps of treating a lithographic printing plate precursor with a first gum solution and subsequently with a second gum solution, wherein both gum solutions are provided in a cascade configuration whereby the second gum solution overflows into the first gum solution,
**characterised in that** the processing with the first gum solution is combined with mechanical brushing and/or rubbing by means of one or more flat brush.

14. The method according to claim 13 wherein the first and second gum solutions independently have a pH-value from 0 to 8.

15. The method according to claims 13 or 14 wherein the processing with the second gum solution is combined with mechanical brushing and/or rubbing by means of one or more round circular brush(es).
